(19) Europäisches Patentamt
European Patent Office
Office européen des brevets

(11) EP 4 775 330 A1

(12) **EUROPEAN PATENT APPLICATION**
published in accordance with Art. 153(4) EPC

(43) Date of publication:
**15.07.2026 Bulletin 2026/29**

(21) Application number: **24862705.1**

(22) Date of filing: **29.08.2024**

(51) International Patent Classification (IPC):
***B22F 1/102*** *(2022.01)* ***B22F 1/00*** *(2022.01)*
***B22F 1/054*** *(2022.01)* ***B22F 9/00*** *(2006.01)*
***B22F 9/24*** *(2006.01)* ***H01B 1/00*** *(2006.01)*
***H01B 1/22*** *(2006.01)* ***H01B 5/00*** *(2006.01)*
***H01L 21/52*** *(2006.01)*

(52) Cooperative Patent Classification (CPC):
**B22F 1/00; B22F 1/054; B22F 1/102; B22F 9/00; B22F 9/24; H01B 1/00; H01B 1/22; H01B 5/00; H10W 72/071**

(86) International application number:
**PCT/JP2024/031078**

(87) International publication number:
**WO 2025/053053 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.09.2023 JP 2023145614**

(71) Applicant: **Osaka Soda Co., Ltd.**
**Osaka-shi, Osaka 530-0001 (JP)**

(72) Inventors:
- **TOMOTOSHI, Daisuke**
  **Osaka-shi, Osaka 550-0011 (JP)**
- **MORI, Takamichi**
  **Osaka-shi, Osaka 550-0011 (JP)**
- **OKUDA, Masatoshi**
  **Osaka-shi, Osaka 550-0011 (JP)**

(74) Representative: **Müller-Boré & Partner Patentanwälte PartG mbB**
**Friedenheimer Brücke 21**
**80639 München (DE)**

# (54) SILVER PARTICLES

(57) The present invention provides novel silver particles which, in a case of being used as a conductive adhesive, allow a sintered body obtained by sintering of the conductive adhesive in a nitrogen atmosphere to be excellent in adhesion to a copper member, and when a shear force is applied to the sintered body which is in firm contact with the copper member, high mechanical strength (shear strength) is exhibited. Silver particles in each of which a compound represented by the following general formula (1) is attached to a surface of the silver particle. [In general formula (1), $R^1$ is an alkyl group having 2 to 8 carbon atoms, $R^2$ is an alkyl group having 1 to 4 carbon atoms, and $R^3$ is a hydrogen atom or an alkyl group having 1 to 4 carbon atoms.]

EP 4 775 330 A1

## Description

### Technical Field

The present invention relates to silver particles, a conductive adhesive, a sintered body of the conductive adhesive, and an electronic part comprising the sintered body between members.

### Background Art

Conductive adhesives, such as die-bonding agents, are bonding materials used in electronic parts such as semiconductors, LEDs, and power semiconductors. A commonly known bonding method involves bonding such a bonding material to a substrate, by bonding with pressure and heat, or by sintering with heat or the like without pressure. Bonding materials for the non-pressure method are recently being developed, from the viewpoint of the efficiency and simplicity of the production process.

Conductive adhesives containing silver particles are recently being developed. Silver particles have the property of being easily sintered by a heat treatment at low temperature in a short period of time. PTL 1, for example, discloses a metal paste obtained by kneading solids composed of silver particles and a solvent, wherein the solids are composed of silver particles including 30% or more of silver particles with particle diameters of 100 to 200 nm on the basis of the number of particles, and an amine compound having 4 to 8 carbon atoms in total is bound as a protective agent to the silver particles constituting the solids. According to PTL 1, this metal paste allows 0sintering of the silver particles at a temperature in a low-temperature range and is also capable of forming a sintered body having low resistance or a sintered body having excellent thermal conductivity.

### Citation List

### Patent Literature

PTL 1: Japanese Patent Laid-open Publication No. 2015-159096

### Summary of Invention

### Technical Problem

A conductive adhesive containing silver particles is a dispersion of silver particles in a solvent, and can be applied to the surface of a member (e.g., a substrate, a semiconductor chip, or the like used in an electronic part) and sintered to bond members.

For example, when a conductive adhesive containing silver particles is applied in a process of manufacturing a member such as a substrate or a semiconductor chip used for an electronic part, it is required to conduct the manufacturing process in a nitrogen atmosphere to suppress degradation of the member (for example, degradation due to heating in the air). In addition, there is also an advantage that the manufacturing process can be conducted under a certain environment by manufacturing the product under a nitrogen atmosphere.

In addition, for example, in the case of applying a conductive adhesive containing silver particles to a copper member such as a copper substrate, it is necessary to sinter the conductive adhesive under a nitrogen atmosphere rather than an air atmosphere.

However, when a conductive adhesive containing conventional silver particles is applied to copper members and sintered under a nitrogen atmosphere to obtain a laminate, the adhesion of the sintered body to the copper members may be insufficient (specifically, when a shear force is applied to the sintered body in close contact with a copper member, the mechanical strength (shear strength) of the laminate is low, and the sintered body and the copper member are easily peeled off.).

Under such circumstances, it is a main object of the present invention to provide novel silver particles which, in a case where the silver particles are used for a conductive adhesive, allow a laminate of a sintered body and a copper member obtained by sintering of the conductive adhesive on the surface of the copper member in a nitrogen atmosphere to be excellent in adhesion, and which allow high mechanical strength (shear strength) to be exhibited when a shear force is applied to the sintered body of the laminate. Furthermore, it is also an object of the present invention to provide a conductive adhesive comprising the silver particles, a sintered body of the conductive adhesive, and an electronic part comprising the sintered body between members.

Solution to Problem

The present inventors conducted extensive research to solve the aforementioned problem. As a result, they have obtained a novel finding that by using novel silver particles in which a prescribed acidic compound is attached to the surfaces of silver particles composed of silver for a conductive adhesive, excellent adhesion between a sintered body obtained by sintering the conductive adhesive under a nitrogen atmosphere and a copper member is achieved. The present invention has been accomplished by repetitively conducting further studies on the basis of this finding.
In summary, the present invention provides aspects of the invention as itemized below.

Item 1. Silver particles in each of which a compound represented by the following general formula (1) adheres to a surface of the silver particle.

[Chemical Formula 1]

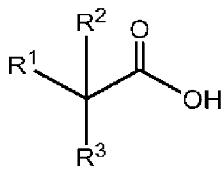
(1)

In general formula (1), $R^1$ is an alkyl group having 2 to 8 carbon atoms, $R^2$ is an alkyl group having 1 to 4 carbon atoms, and $R^3$ is a hydrogen atom or an alkyl group having 1 to 4 carbon atoms.
Item 2. The silver particles according to item 1, wherein the silver particles have an average particle diameter of 60 to 600 nm.
Item 3. The silver particles according to item 1 or 2, wherein the silver particles are dispersed in a solvent.
Item 4. The silver particles according to item 3, wherein when a concentration of the silver particles in the solvent is 50% by mass, a value of SPAN as measured by a photocentrifuge method under the following conditions is 0.1 or more and 5.0 or less.

$$\text{SPAN: } (X90 - X10)/X50 \cdots \text{Expression (1)}$$

wherein when the particle diameter is expressed by a cumulative distribution,
X10 is a particle diameter at 10% of a cumulative particle size distribution;
X90 is a particle diameter at 90% of the cumulative particle size distribution;
X50 (median particle diameter) is a particle diameter at 50% of the cumulative particle size distribution.

(Measurement conditions for SPAN)

A measurement sample in which the concentration of the silver particles in the solvent is 50% by mass is prepared; a solvent having an octanol/water partition coefficient (Log Pow) of -2 or more and 4 or less is used as the solvent of the measurement sample; a glass cell (a glass cell with an optical path length of 2 mm) is charged with 0.2 ml of the measurement sample; under a temperature condition of 25°C, the glass cell is rotated at a low speed at a centrifugal acceleration of 130 G, and data for 500 points are obtained at an interval of 5 seconds, and then the glass cell is rotated at a high speed at a centrifugal acceleration of 1160 G, and data for 500 points are obtained at an interval of 5 seconds; three points between a gas-liquid interface (the liquid surface of the measurement sample) and a solid-liquid interface (the interface between sedimented silver particles and the solvent) of the measurement sample are arbitrarily selected, and each of the three points is analyzed at a node width of 1 mm; each of the sedimentation velocities is calculated from a moving distance of the particles and a time required for the movement, the sedimentation velocities are converted into particle diameters using the viscosity and the refractive index of the solvent used, whereby the particle diameters X90, X10, and X50 are determined; and the SPAN is calculated based on Expression (1).

Item 5. A conductive adhesive comprising the silver particles according to any one of items 1 to 4.
Item 6. A conductive adhesive comprising the silver particles according to any one of items 1 to 4 and a resin.
Item 7. A sintered body of the conductive adhesive according to item 5.
Item 8. An electronic part in which members are bonded with the sintered body according to item 7.

Advantageous Effects of Invention

According to the present invention, it is possible to provide novel silver particles which, in a case where the silver particles are used for a conductive adhesive, allow a laminate of a sintered body and a copper member obtained by sintering of the conductive adhesive on the surface of the copper member in a nitrogen atmosphere to be excellent in adhesion, and which allow high mechanical strength (shear strength) to be exhibited when a shear force is applied to the sintered body of the laminate.
According to the present invention, it is also possible to provide a conductive adhesive comprising the silver particles, a sintered body of the conductive adhesive, and an electronic part comprising the sintered body between members.

Description of Embodiments

In the silver particles of the present invention, a compound represented by the following general formula (1) is attached to the surfaces of silver particles composed of silver. Due to the fact that such a specific acidic compound is attached to the surfaces of the particles composed of silver, when the silver particles of the present invention are used as a conductive adhesive, a sintered body obtained by sintering of the conductive adhesive in a nitrogen atmosphere is excellent in adhesion to a copper member, and when a shear force is applied to the sintered body which is in firm contact with the copper member, high mechanical strength (shear strength) is exhibited. The silver particles of the present invention, a conductive adhesive, a sintered body of the conductive adhesive, and an electronic part comprising the sintered body between members will hereinafter be described in detail.

[Chemical Formula 2]

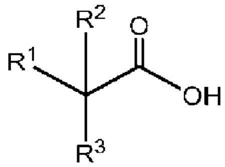 (1)

In the general formula (1), $R^1$ is an alkyl group having 2 to 8 carbon atoms, $R^2$ is an alkyl group having 1 to 4 carbon atoms, and $R^3$ is a hydrogen atom or an alkyl group having 1 to 4 carbon atoms.
In the present description, values joined by "to" mean a numerical range including the values before and after "to" as the lower and upper limits. When a plurality of lower limit values and a plurality of upper limit values are written separately, an arbitrary lower limit value and an arbitrary upper limit value may be selected and joined by "to".

1. Silver particles

The silver particles of the present invention are particles containing silver. The compound represented by the formula (1) (hereinafter sometimes referred to as compound (1)) is attached to surfaces of the silver particles. That is, the silver particles of the present invention have a structure in which the compound (1) is attached to the surface of a particle composed of silver.
In the present invention, a particle composed of silver in which the compound (1) is not attached to the surface of the particle (a particle composed of substantially only silver) is expressed as "silver particle", and, for convenience, a particle composed of silver in which the compound (1) is attached to the surface of the particle is also expressed as "silver particle". The expression "silver particles of the present invention" means particles in which the compound (1) is attached to the surfaces of particles composed of silver.
In the silver particles of the present invention, the compound (1) attached to the surfaces of the silver particles can be expressed as forming a protective layer (or a surface layer or the like). Specifically, the silver particles include a protective layer on the surfaces of particles composed of silver. The protective layer contains the compound represented by the general formula (1). Due to the fact that the conductive adhesive of the present invention contains silver particles having such a protective layer, a laminate of a sintered body and a copper member obtained by sintering of the conductive adhesive in a nitrogen atmosphere is excellent in adhesion, and in the laminate, when a shear force is applied to the sintered body which is in firm contact with the copper member, high mechanical strength (shear strength) is exhibited.
As described above, in the general formula (1), $R^1$ is an alkyl group having 2 to 8 carbon atoms, and from the viewpoint of more suitably exhibiting the effect of the present invention, $R^1$ is preferably an alkyl group having 3 to 7 carbon atoms, and more preferably an alkyl group having 3 to 6 carbon atoms.
In the general formula (1), $R^2$ is an alkyl group having 1 to 4 carbon atoms, and from the viewpoint of more suitably

exhibiting the effect of the present invention, $R^2$ is preferably an alkyl group having 1 to 3 carbon atoms, and more preferably an alkyl group having 1 to 2 carbon atoms.

In the general formula (1), $R^3$ is a hydrogen atom or an alkyl group having 1 to 4 carbon atoms, and from the viewpoint of more suitably exhibiting the effect of the present invention, $R^3$ is preferably a hydrogen atom or an alkyl group having 1 to 2 carbon atoms, and more preferably a hydrogen atom.

From the viewpoint of more suitably exhibiting the effect of the present invention, among the compounds represented by the general formula (1), 2-methylbutanoic acid, 2-ethylbutanoic acid, 2,2-dimethylbutanoic acid, 2-methylpentanoic acid, 2,2-dimethylpentanoic acid, 2-ethylpentanoic acid, 2-propylpentanoic acid, 2-methylhexanoic acid, 2,2-dimethylhexanoic acid, 2-ethylhexanoic acid, 2,2-diethylhexanoic acid, 2-propylhexanoic acid, 2-butylhexanoic acid, 2-methylheptanoic acid, 2-ethylheptanoic acid, 2-propylheptanoic acid, 2-methyloctanoic acid, 2-ethyloctanoic acid, 2-propyloctanoic acid, 2-methylnonanoic acid, 2-ethylnonanoic acid, 2-methyldecanoic acid, 2-ethyldecanoic acid, and the like are preferred, and 2-ethylhexanoic acid is particularly preferred. The compound represented by the general formula (1) contained in the protective layer may be either one compound or two or more compounds.

The amount of the compound (1) to be attached to the silver particles of the present invention is not particularly limited, but is preferably 1.5% by mass or less, and more preferably 1.3% by mass or less based on the mass of the silver particles taken as 100% by mass, and the lower limit is preferably 0.05% by mass or more. The content of the compound (1) attached to the silver particles can be measured by thermogravimetry-differential thermal analysis.

In addition, the protective layer may contain a compound different from the compound represented by the general formula (1). Examples of the different compound include an amine compound, a fatty acid, and a hydroxy fatty acid. When a compound different from the compound represented by the general formula (1) is contained in the protective layer, the different compound contained in the protective layer may be either one compound or two or more compounds.

While the amine compound is not particularly limited, it is preferably an alkylamine in which the alkyl group contains 3 or more and 18 or less carbon atoms, and is more preferably an alkylamine in which the alkyl group contains 4 or more and 12 or less carbon atoms.

Preferred examples of the alkylamine include ethylamine, n-propylamine, isopropylamine, 1,2-dimethylpropylamine, n-butylamine, isobutylamine, sec-butylamine, tert-butylamine, isoamylamine, tert-amylamine, 3-pentylamine, n-amylamine, n-hexylamine, n-heptylamine, n-octylamine, 2-octylamine, 2-ethylhexylamine, n-nonylamine, n-aminodecane, n-aminoundecane, n-dodecylamine, n-tridecylamine, 2-tridecylamine, n-tetradecylamine, n-pentadecylamine, n-hexadecylamine, n-heptadecylamine, n-octadecylamine, n-oleylamine, N-ethyl-1,3-diaminopropane, N,N-diisopropylethylamine, N,N-dimethylaminopropane, N,N-dibutylaminopropane, N,N-dimethyl-1,3-diaminopropane, N,N-diethyl-1,3-diaminopropane, N,N-diisobutyl-1,3-diaminopropane, and N-lauryldiaminopropane. Furthermore, additional examples include dibutylamine, which is a secondary amine, and cyclopropylamine, cyclobutylamine, cyclopropylamine, cyclohexylamine, cycloheptylamine, cyclooctylamine, and 2-(2-aminoethylamino)ethanol, which are cyclic alkylamines. Among them, from the viewpoint of more suitably exhibiting the effect of the present invention, n-propylamine, isopropylamine, cyclopropylamine, n-butylamine, isobutylamine, sec-butylamine, tert-butylamine, cyclobutylamine, n-amylamine, n-hexylamine, cyclohexylamine, n-octylamine, 2-ethylhexylamine, n-dodecylamine, n-oleylamine, N,N-dimethyl-1,3-diaminopropane, and N,N-diethyl-1,3-diaminopropane are preferable, n-butylamine, n-hexylamine, cyclohexylamine, n-octylamine, n-dodecylamine, N,N-dimethyl-1,3-diaminopropane, and N,N-diethyl-1,3-diaminopropane are more preferable, and n-hexylamine is particularly preferable. As the compound (1), one compound may be used alone, or alternatively two or more compounds may be used in combination.

In the silver particles of the present invention, the amount of the amine compound to be attached is also appropriately adjusted in the same manner as in the compound (1). A specific amount of the amine compound to be attached is not particularly limited, but is preferably 1.5% by mass or less, more preferably 1.3% by mass or less based on the mass of the silver particles taken as 100% by mass, and the lower limit is 0.00% by mass, 0.01% by mass or more, or the like. The content of the amine compound attached to the silver particles can be measured by differential thermal analysis.

In addition, a fatty acid, a hydroxy fatty acid, or the like may be attached to the surface of the silver particles. While the fatty acid is not particularly limited, it is preferably a fatty acid in which the alkyl group contains 3 or more and 18 or less carbon atoms, and is more preferably a fatty acid in which the alkyl group contains 4 or more and 18 or less carbon atoms. Preferred examples of the fatty acid include acetic acid, propionic acid, butyric acid, valeric acid, caproic acid, caprylic acid, capric acid, lauric acid, myristic acid, palmitic acid, stearic acid, oleic acid, linoleic acid, and $\alpha$-linolenic acid. Examples of the fatty acid also include cyclic alkyl carboxylic acids such as cyclohexanecarboxylic acid. The hydroxy fatty acid may be a compound having 3 to 24 carbon atoms and having one or more (for example, one) hydroxyl group(s). Examples of the hydroxy fatty acid include 2-hydroxydecanoic acid, 2-hydroxydodecanoic acid, 2-hydroxytetradecanoic acid, 2-hydroxyhexadecanoic acid, 2-hydroxyoctadecanoic acid, 2-hydroxyeicosanoic acid, 2-hydroxydocosanoic acid, 2-hydroxytricosanoic acid, 2-hydroxytetracosanoic acid, 3-hydroxyhexanoic acid, 3-hydroxyoctanoic acid, 3-hydroxynonanoic acid, 3-hydroxydecanoic acid, 3-hydroxyundecanoic acid, 3-hydroxydodecanoic acid, 3-hydroxytridecanoic acid, 3-hydroxytetradecanoic acid, 3-hydroxyhexadecanoic acid, 3-hydroxyheptadecanoic acid, 3-hydroxyoctadecanoic acid, $\omega$-hydroxy-2-decenoic acid, $\omega$-hydroxypentadecanoic acid, $\omega$-hydroxyheptadecanoic acid, $\omega$-hydroxyeicosanoic acid, $\omega$-hydro-

xydocosanoic acid, 6-hydroxyoctadecanoic acid, ricinoleic acid, 12-hydroxystearic acid, and [R-(E)]-12-hydroxy-9-octadecenoic acid. Preferred among the above are hydroxy fatty acids containing 4 to 18 carbon atoms and having one hydroxyl group at a position other than the $\omega$-position (particularly the 12-position), and more preferred are ricinoleic acid and 12-hydroxystearic acid. As each of the fatty acid and the hydroxy fatty acid, one compound may be used alone, or alternatively two or more compounds may be used in combination.

In the silver particles of the present invention, the amount of the fatty acid or the hydroxy fatty acid to be attached is also adjusted appropriately, as with the compound (1). While the specific amount of the fatty acid or the hydroxy fatty acid to be attached is not particularly limited, it is preferably 1.5% by mass or less, and more preferably 1.3% by mass or less, based on the mass of the silver particles taken as 100% by mass. The lower limit is 0.01% by mass, 0.01% by mass or more, or the like. The content of the fatty acid or the hydroxy fatty acid attached to the silver particles can be measured by differential thermal analysis.

As long as the compound (1) is attached to the surfaces of the silver particles of the present invention and the effect of the present invention can be exhibited, the compound (1), the amine compound, the fatty acid, and the hydroxy fatty acid may be used in combination, or other compounds different from these compounds may be attached to the surfaces of the silver particles.

The silver particles of the present invention can be prepared in a dispersed state in a solvent. In this case, the silver particles of the present invention exist in a state where the silver particles are dispersed in a solvent. The solvent is not particularly limited as long as the silver particles of the present invention are brought into a dispersed state, but a solvent having an octanol/water partition coefficient (Log Pow) of -2 or more and 4 or less is preferable.

From the viewpoint of satisfactorily achieving the effect of the present invention, preferred examples of the solvent include diethylene glycol monohexyl ether (Log Pow: 1.7), Texanol (Log Pow: 3.2), isopropyl alcohol (Log Pow: 0.05), $\alpha$-terpineol (Log Pow: 2.98), diethylene glycol (Log Pow: -1.98), ethylene glycol (Log Pow: -1.36), 2-ethyl-1,3-hexanediol (Log Pow: 1.60), diethylene glycol mono-2-ethylhexyl ether (Log Pow: 2.23), butyl carbitol (Log Pow: 0.56), butyl carbitol acetate (Log Pow: 2.9), and butanediol (Log Pow: -0.34). The solvent may be either only a single solvent or two or more solvents, and preferably is a single solvent.

From the viewpoint of more satisfactorily achieving the effect of the present invention, the concentration of the silver particles of the present invention in the solvent is preferably 80% by mass or more, more preferably 85% by mass or more, and still more preferably 88% by mass or more, while the concentration is preferably 95% by mass or less, more preferably 93% by mass or less, and still more preferably 92% by mass or less. Preferred ranges include from 80 to 95% by mass, from 85 to 93% by mass, and from 88 to 92% by mass. When the value of SPAN: (X90 - X10)/X50 described later is measured for the silver particles of the present invention, the measurement is conducted with the concentration adjusted to 50% by mass.

The value of SPAN: (X90 - X10)/X50 of the silver particles of the present invention as measured by a photocentrifuge method under the above conditions is preferably 0.1 or more and 5.0 or less. The value of SPAN: (X90 - X10)/X50 as measured by the photocentrifuge method is correlated with the particle size distribution of secondary particles of the silver particles, and it can be said that the smaller the value of SPAN: (X90 - X10)/X50 is, the narrower the particle size distribution of the secondary particles of the silver particles is. In the present invention, when the value of SPAN: (X90 - X10)/X50 of the silver particles to which the compound (1) is attached is within a specific range of from 0.1 to 5.0, it can be evaluated that the particle size distribution of the silver particles as secondary particles is within an appropriate range, further aggregation of the secondary particles is suppressed, and the silver particles are appropriately dispersed in the solvent. Attempts have previously been made to adjust the properties of a conductive adhesives containing silver particles by controlling the primary particles of the silver particles. In contrast, the present invention focuses on the dispersibility of the secondary particles of the silver particles, and controls the value of SPAN: (X90 - X10)/X50 as measured by the photocentrifuge method within the specific range, thereby imparting both good fluidity and excellent sinterability to silver particles dispersed in the solvent. As a result, the effect of the present invention can be more suitably exhibited. Specific measurement conditions for the photocentrifuge method are described in Examples.

From the viewpoint of suitably exhibiting the effect of the present invention, the value of the SPAN: (X90 - X10)/X50 of the silver particles of the present invention is preferably 0.1 or more, more preferably 0.2 or more, still more preferably 0.3 or more, and particularly preferably 0.4 or more. In addition, the value of the SPAN is preferably 5.0 or less, more preferably 4.9 or less, still more preferably 4.8 or less, and particularly preferably 4.7 or less. Preferable ranges include from 0.1 to 5.0, from 0.2 to 4.9, from 0.3 to 4.8, and from 0.4 to 4.7.

In the present invention, the method of setting the value of SPAN: (X90 - X10)/X50 of the silver particles within the specific range of 0.1 to 5.0 is not specifically limited; however, the value of SPAN can be adjusted as described below, for example, with the purification solvent (washing solvent) used to produce the silver particles, the washing method using the solvent, the solvent used for replacing the amine compound on the surfaces of the silver particles with an acid (protective group) (that is, the compound (1)), the selection of the dispersion solvent or the method of dispersing the silver particles in the dispersion solvent, and the centrifugation conditions during production of the silver particles where concentration is required. In particular, the purification solvent needs to be selected according to the particle diameter and the protective

group. If an appropriate purification solvent is not used, the particle size distribution of the secondary particles may be broadened when prepared as a high-concentration dispersion, or extremely large secondary particles may be produced. Furthermore, centrifugation conditions involving the application of an excessively high load G similarly affect the secondary particles. In addition, excessively low centrifugation conditions tend to broaden the distribution of the secondary particles. It is thus necessary to appropriately determine the centrifugation conditions according to the particle diameter and the type of the solvent used during centrifugation.

In addition, from the viewpoint of suitably exhibiting the effect of the present invention, the average particle diameter (primary particle diameter) of the silver particles is, for example, 600 nm or less, preferably 580 nm or less, more preferably 560 nm or less, and still more preferably 550 nm or less, and is preferably 50 nm or more, more preferably 60 nm or more, and still more preferably 65 nm or more. Preferable ranges include from 50 to 600 nm, from 50 to 580 nm, from 50 to 560 nm, from 50 to 550 nm, from 60 to 600 nm, from 60 to 580 nm, from 60 to 560 nm, from 60 to 550 nm, from 65 to 600 nm, from 65 to 580 nm, from 65 to 560 nm, and from 65 to 550 nm.

For example, a conductive adhesive containing silver particles having an average particle diameter of about 100 nm (about 50 to about 150 nm) can be suitably used for a joint portion of a power device in a thin film, solar cell applications, and the like because of its excellent sinterability. In addition, for example, a conductive adhesive containing silver particles having an average particle diameter of about 200 nm (about 150 to about 300 nm) exhibits low shrinkage while maintaining sinterability, and thus can be suitably used for a joint portion of a power device or a power amplifier. In addition, for example, a conductive adhesive containing silver particles having an average particle diameter of about 500 nm (about 300 to about 600 nm) exhibits low shrinkage, and thus can be suitably used for a joint portion of a power device in a thick film. Characteristics required vary depending on the application of the conductive adhesive, but the conductive adhesive of the present invention can be made into a conductive adhesive suitable for each application by adjusting the average particle diameter of the silver particles of the present invention.

The average particle diameter (primary particle diameter) of the silver particles of the present invention refers to the volume-based average particle diameter measured for 200 randomly selected particles in a SEM image, using image analysis software (for example, Macview (available from Mountech Co., Ltd.)). The SED mode (secondary electron detector) is used in the observation, and a range with a lateral width of 1 to 20 μm is observed at an acceleration voltage of 20 kV and a magnification of 5000 to 30000 times. With respect to the vertical direction of the SEM image, the width is set such that 200 or more (typically about 200 to about 300) silver particles are included in the range with a lateral width of 1 to 20 μm. The volume-based average particle diameter refers to the value measured on the basis of the assumption that the particles observed in the SEM image have a spherical shape with that diameter. The specific measurement method is as described in Examples.

In addition, from the viewpoint of suitably exhibiting the effect of the present invention, in the silver particles of the present invention, at least one or more exothermic peaks in thermogravimetry-differential thermal analysis are preferably observed in the range of 120 to 300°C, more preferably at least one or more exothermic peaks are observed in the range of 120 to 160°C, and still more preferably at least one or more exothermic peaks are observed in the range of 160 to 300°C. Usually, one or more such exothermic peaks are observed in these ranges.

A dry powder of the silver particles of the present invention preferably exhibits a weight loss of 1.5% by weight or less, and more preferably exhibits a weight loss of 0.05 to 1.3% by weight, upon heating from 30 to 500°C by thermogravimetry-differential thermal analysis. The method of thermogravimetry-differential thermal analysis is as follows.

<Thermogravimetry-differential thermal analysis (TG-DTA)>

The TG-DTA of silver particles dispersed in a solvent is measured with a thermogravimetry-differential thermal analyzer (for example, HITACHI G300 AST-2). The measurement conditions are as follows: atmosphere: air (in the case of measuring the silver content in a dispersion) or nitrogen (in the case of measuring an exothermic peak or the weight loss), measurement temperature: 30 to 500°C, heating rate: 10°C/min. From the obtained TG-DTA chart, the exothermic peak due to binding of the silver particles in the TG-DTA analysis and the weight loss on heating from 30 to 500°C by the thermal analysis are obtained.

The silver content in the silver particles of the present invention is preferably 95% by mass or more, and more preferably 98% by mass or more.

The compound (1) is attached to the surfaces of the silver particles of the present invention. That is, the silver particles of the present invention have been surface-treated with a treatment liquid containing the compound (1) (surface-treated silver particles). The compound (1) is attached to the surfaces of the silver particles to form a protective layer.

2. Method for producing silver particles

One exemplary method for producing the silver particles of the present invention will hereinafter be described.

First, a composition for producing the silver particles (particles composed of silver) of the present invention (a silver particle-preparation composition) is prepared. Specifically, a silver compound as a raw material of the silver particles, the compound (1) to be attached to the surface of the silver particles, and solvents to be used in respective steps (a solvent to be used for synthesis of the silver particles, a purification solvent for the silver particles, a solvent for replacing the amine compound with the compound (1), etc.) are prepared.

The silver particles of the present invention are synthesized through the step of synthesizing silver particles (particles composed of silver) from the silver compound, the below-described step of replacing the amine compound on the surfaces of the silver particles with an acid (protective group) (that is, the compound (1)), and the like, and separation of the silver particles may be included during each of the steps or between the steps.

From the viewpoint of more satisfactorily achieving the effect of the present invention, examples of preferable silver compounds include silver nitrate and silver oxalate, and silver oxalate is particularly preferable.

The solvent to be used for synthesizing the silver particles from the silver compound is not specifically limited as long as it allows synthesis of the silver particles composed of silver, but the solvent preferably contains a polar organic solvent. Examples of the polar organic solvent include ketones, such as acetone, acetylacetone, and methyl ethyl ketone; ethers, such as diethyl ether, dipropyl ether, dibutyl ether, tetrahydrofuran, and 1,4-dioxane; diols, such as 1,2-propanediol, 1,2-butanediol, 1,3-butanediol, 1,4-butanediol, 2,3-butanediol, 1,2-hexanediol, 1,6-hexanediol, 1,2-pentanediol, 1,5-pentanediol, 2-methyl-2,4-pentanediol, 3-methyl-1,5-pentanediol, 1,2-octanediol, 1,8-octanediol, and 2-ethyl-1,3-hexanediol; glycerol; alcohols, such as linear or branched alcohols containing 1 to 5 carbon atoms, cyclohexanol, 3-methoxy-3-methyl-1-butanol, and 3-methoxy-1-butanol; fatty acid esters, such as ethyl acetate, butyl acetate, ethyl butyrate, ethyl formate, and Texanol; glycols or glycol ethers, such as polyethylene glycol, triethylene glycol monomethyl ether, tetraethylene glycol monomethyl ether, ethylene glycol monoethyl ether, diethylene glycol monoethyl ether, diethylene glycol dimethyl ether, triethylene glycol dimethyl ether, tetraethylene glycol dimethyl ether, 3-methoxybutyl acetate, ethylene glycol monobutyl ether, ethylene glycol monobutyl ether acetate, ethylene glycol monohexyl ether, ethylene glycol monooctyl ether, ethylene glycol mono-2-ethylhexyl ether, ethylene glycol monobenzyl ether, diethylene glycol monomethyl ether, diethylene glycol monomethyl ether acetate, diethylene glycol monoethyl ether, diethylene glycol monoethyl ether acetate, diethylene glycol monobutyl ether, diethylene glycol monobutyl ether acetate, diethylene glycol monohexyl ether, diethylene glycol mono-2-ethylhexyl ether, polypropylene glycol, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tripropylene glycol monoethyl ether, tripropylene glycol monopropyl ether, and tripropylene glycol monobutyl ether; N,N-dimethylformamide; dimethyl sulfoxide; terpenes, such as terpineol; acetonitrile; $\gamma$-butyrolactone; 2-pyrrolidone; N-methylpyrrolidone; and N-(2-aminoethyl)piperazine. From the viewpoint of more satisfactorily achieving the effect of the present invention, preferred among the above are linear or branched alcohols containing 3 to 5 carbon atoms, 3-methoxy-3-methyl-1-butanol, 3-methoxy-1-butanol, diethylene glycol monobutyl ether, diethylene glycol monobutyl ether acetate, diethylene glycol monohexyl ether, diethylene glycol mono-2-ethylhexyl ether, terpineol, and Texanol.

The solvent may further contain a nonpolar or hydrophobic solvent in addition to the polar organic solvent. Examples of the nonpolar organic solvent include linear, branched, or cyclic saturated hydrocarbons, such as hexane, heptane, octane, nonane, decane, 2-ethylhexane, and cyclohexane; alcohols, such as linear or branched alcohols containing 6 or more carbon atoms; aromatic compounds, such as benzene, toluene, and benzonitrile; halogenated hydrocarbons, such as dichloromethane, chloroform, and dichloroethane; methyl-n-amyl ketone; methyl ethyl ketone oxime; and triacetin. Preferred among the above are saturated hydrocarbons and linear or branched alcohols containing 6 or more carbon atoms, and more preferred are hexane, octane, decane, octanol, decanol, and dodecanol. A single solvent may be used, or alternatively, two or more solvents may be used as a mixture.

In the step of synthesizing the silver particles from the silver compound, the silver compound, the compound (1), and the solvent are mixed to afford a silver particle-preparation composition. The proportions of these components in the composition are appropriately adjusted. For example, the content of silver oxalate in the composition is preferably about 20 to about 70% by mass based on the total amount of the composition. The content of the compound (1) is preferably about 5 to about 55% by mass based on the total amount of the composition. When the fatty acid is to be attached to the surfaces of the silver particles, the content of the fatty acid is preferably about 0.1 to about 20% by mass based on the total amount of the composition. When the hydroxy fatty acid is attached to the surfaces of the silver particles, the content of the hydroxy fatty acid is preferably about 0.1 to about 15% by mass based on the total amount of the composition.

After the synthesis of silver particles to which the amine compound is attached, the amine compound can be replaced with the compound (1) by the method described below.

The means of mixing the components is not particularly limited, and the mixing may be conducted using a general-purpose device, such as a mechanical stirrer, a magnetic stirrer, a vortex mixer, a planetary mill, a ball mill, a three-roll, a line mixer, a planetary mixer, or a dissolver. To avoid an increase in the temperature of the composition, which may initiate the pyrolysis reaction of the silver particles, due to the influence of the heat of dissolution, frictional heat, and the like during mixing, it is preferred to perform the mixing while keeping the temperature of the composition at, for example, 60°C

or less, particularly 40°C or less.

Next, the silver particle-preparation composition is subjected to a reaction, typically a reaction by heating, in a reaction vessel, whereby the pyrolysis reaction of the silver compound is caused, resulting in the generation of silver particles. The reaction may be performed by introducing the composition into a pre-heated reaction vessel, or introducing the composition into a reaction vessel and then heating.

The reaction temperature may be any temperature at which the pyrolysis reaction proceeds and the silver particles are generated, for example, may be about 50 to about 250°C. The reaction time may be selected appropriately according to the desired size of the average particle diameter and the corresponding composition of the composition. The reaction time is, for example, 1 minute to 100 hours.

The silver particles generated by the pyrolysis reaction are obtained as a mixture containing unreacted raw materials, and therefore, the silver particles are preferably purified. Examples of the purification method include a solid-liquid separation method and a precipitation method utilizing a difference in specific gravity between the silver particles and the unreacted raw materials, such as an organic solvent. Examples of the solid-liquid separation method include filtration, centrifugation, a cyclone method, and decantation. To make handling during purification easy, the viscosity of the mixture containing the silver particles may be adjusted by diluting the mixture with a low-boiling solvent, such as acetone or methanol.

The average particle diameter (primary particle diameter) of the silver particles to be obtained can be adjusted by adjusting the composition and reaction conditions of the silver particle-production composition. In the present invention, from the viewpoint of setting the value of the SPAN: (X90 - X10)/X50 within the specific range described above, n-propanol, 1-butanol, or the like is preferably used as the purification solvent. The choice of the purification solvent affects the value of said SPAN: (X90 - X10)/X50 of the silver particles of the present invention.

Method of replacing and adjusting amine compound and the like on surfaces of silver particles

Silver particles (in which the amine compound is attached to the surfaces) previously synthesized using the method described above are prepared and then dispersed in a solvent. Examples of the solvent include the same solvents as those recited as examples of the solvent to be used in the step of synthesizing the silver particles, but it is preferable to use ethanol, n-propanol, isopropyl alcohol, 1-butanol, or the like. The selection of the solvent to be used for replacing and adjusting the compound (1) on the surfaces of the silver particles affects the value of SPAN: (X90 - X10)/X50 of the silver particles of the present invention. Next, another compound (1) is added in an amount in the range of 0.1 to 5 times the mass of the silver particles, and the mixture is subjected to the step of stirring for 1 minute to 24 hours at room temperature to 80°C. As a result, the amine compound attached to the surfaces of the silver particles can be replaced with the compound (1). The silver particles in which the amine compound on the surfaces has been replaced with the compound (1) can be collected using the above-described solid-liquid separation method, or the like. As the solvent used in the solid-liquid separation, ethanol, n-propanol, isopropyl alcohol, 1-butanol, or the like is preferably used. The choice of the solvent also affects the value of the SPAN: (X90 - X10)/X50 of the silver particles of the present invention.

3. Conductive adhesive

The conductive adhesive of the present invention comprises the silver particles of the present invention. That is, the conductive adhesive of the present invention comprises the silver particles of the present invention and a solvent. The details of the silver particles of the present invention and the solvent are as described above.

The conductive adhesive of the present invention may further comprise a resin in addition to the silver particles of the present invention and the solvent. The resin is not particularly limited, and any resin used in conductive adhesives containing known silver particles, for example, thermoplastic resins and thermosetting resins, can be used also in the present invention. Examples of thermoplastic resins include urethane resins, acrylic resins, methacrylic resins, polyvinyl alcohol resins, vinyl acetate resins, polycarbonate resins, polyorganosiloxane-based resins, and polyamide resins. These resins may be used as a mixture. Examples of thermosetting resins include epoxy resins, acrylic resins, silicone resins, urethane resins, vinyl ester resins, phenol resins, urea resins, melamine resins, unsaturated polyester resins, diallyl phthalate resins, and polyimide resins. In the present invention, examples of preferred solvents include diethylene glycol monohexyl ether (Log Pow: 1.7), Texanol (Log Pow: 3.2), isopropyl alcohol (Log Pow: 0.05), $\alpha$-terpineol (Log Pow: 2.98), diethylene glycol (Log Pow: - 1.98), ethylene glycol (Log Pow: -1.36), 2-ethyl-1,3-hexanediol (Log Pow: 1.60), diethylene glycol mono-2-ethylhexyl ether (Log Pow: 2.23), butyl carbitol (Log Pow: 0.56), butyl carbitol acetate (Log Pow: 2.9), and butanediol (Log Pow: -0.34). Particularly preferred solvents are diethylene glycol monohexyl ether (Log Pow: 1.7), 2-ethyl-1,3-hexanediol (Log Pow: 1.60), diethylene glycol mono-2-ethylhexyl ether (Log Pow: 2.23), and Texanol (Log Pow: 3.2). When the conductive adhesive of the present invention further comprises a solvent, the solvent contained in the conductive adhesive may be a single solvent or two or more solvents.

The content of the silver particles in the conductive adhesive of the present invention is preferably 80% by mass or

more, more preferably 85% by mass or more, and still more preferably 88% by mass or more, while the content is preferably 95% by mass or less, more preferably 93% by mass or less, and still more preferably 92% by mass or less. Preferred ranges include from 80 to 95% by mass, from 85 to 93% by mass, and from 88 to 92% by mass. When the conductive adhesive of the present invention comprises a resin, the content of the resin in the conductive adhesive of the present invention is preferably 0.001% by mass or more, more preferably 0.005% by mass or more, and still more preferably 0.01% by mass or more, while the content is preferably 10% by mass or less, more preferably 7% by mass or less, and still more preferably 3% by mass or less. Preferred ranges include from 0.001 to 10% by mass, from 0.005 to 7% by mass, and from 0.01 to 3% by mass.

4. Sintered body of conductive adhesive

A sintered body of the conductive adhesive of the present invention is obtained by sintering the conductive adhesive of the present invention described in detail in the "2. Conductive adhesive" section above. In the sintered body of the conductive adhesive of the present invention, the components (the compound (1), etc.) attached to the surfaces of the silver particles and the solvent have been mostly eliminated by the high heat applied during sintering, and the sintered body is substantially composed of silver.

While the sintering temperature is not specifically limited, it is, for example, 300°C or less, preferably about 150 to about 250°C, and more preferably about 200 to about 250°C. The sintering time is preferably about 0.4 to about 2.0 hours, and more preferably about 0.5 to about 1.2 hours. Pressure may or may not be applied during sintering of the conductive adhesive of the present invention. The pressure in the case of pressurization is, for example, about 10 to about 30 MPa. The sintering may be conducted in an atmosphere such as air or an inert gas (nitrogen gas or argon gas). In the present invention, a nitrogen gas atmosphere is particularly preferable. The sintering means is not particularly limited, and examples thereof include an oven, a hot air-type drying oven, an infrared drying oven, laser irradiation, flash lamp irradiation, and microwaves.

5. Electronic part

The electronic part of the present invention comprises a portion where members are bonded with the sintered body of the present invention. That is, the electronic part of the present invention is obtained by placing the conductive adhesive of the present invention described in detail in the "2. Conductive adhesive" section above between members of the electronic part (for example, between members included in a circuit), and sintering the conductive adhesive to bond the members. In the present invention, copper, silver, gold, nickel, aluminum, or the like can be selected as a member to be bonded, and preferably, copper, silver, gold, particularly a copper member is used as a member to be bonded (for example, between copper members, between a copper member and a gold member, between a copper member and a silver member).

Examples

The present invention will be described more specifically by the following examples; however, the present invention is not limited thereto.

Details of the components used in the examples and comparative examples are as follows:

- Silver oxalate ($(COOAg)_2$) was synthesized using the method described in Japanese Patent No. 5574761.
- N,N-Diethyl-1,3-diaminopropane (manufactured by FUJIFILM Wako Pure Chemical Corporation)
- 2-Ethylhexanoic acid (manufactured by Tokyo Chemical Industry Co., Ltd.)
- 2-Hydroxyisobutyric acid (manufactured by Tokyo Chemical Industry Co., Ltd.)
- n-Hexylamine (containing 6 carbon atoms; manufactured by FUJIFILM Wako Pure Chemical Corporation)
- 2-(2-Aminoethylamino)ethanol (manufactured by Tokyo Chemical Industry Co., Ltd.)
- Ricinoleic acid (manufactured by Tokyo Chemical Industry Co., Ltd.)
- Ethylene glycol (manufactured by FUJIFILM Wako Pure Chemical Corporation)
- 1-Butanol (manufactured by FUJIFILM Wako Pure Chemical Corporation)
- Isopropyl alcohol (manufactured by FUJIFILM Wako Pure Chemical Corporation)
- 2-Ethyl-1,3-hexanediol (manufactured by FUJIFILM Wako Pure Chemical Corporation)
- Diethylene glycol mono-2-ethylhexyl ether (manufactured by FUJIFILM Wako Pure Chemical Corporation)

Silver particles were produced by the following procedure. When several samples were required for evaluation, the required number of samples was prepared by increasing the number of attempts following the same method.

<Synthesis Example 1: Synthesis of silver particles 1>

Silver particles 1 dispersed in a solvent were produced by the following procedure. 50-mL glass centrifuge tubes containing a magnetic stirring bar were charged with ricinoleic acid (0.05 g), N,N-diethyl-1,3-diaminopropane (4.1 g), and 1-butanol (7.5 g), followed by stirring for about 1 minute, and then charged with silver oxalate (5 g), followed by stirring for about 10 minutes, affording a silver particles 1-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropanol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. The process including addition of 15 g of isopropanol, stirring, centrifugation, and removal of the supernatant was repeated twice, and then silver particles were collected. Next, using the dispersion (isopropanol solution) of the silver particles obtained above, 2-ethylhexanoic acid was added in an amount of 15 g of the mass of the silver particles, and the mixture was stirred at room temperature for 4 hours. After stirring, the magnetic stirring bar was removed, 15 g of isopropanol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. The process including addition of 15 g of 2-ethyl-1,3-hexanediol, stirring, centrifugation, and removal of the supernatant was repeated twice, and then silver particles 1 were collected.

<Synthesis Example 2: Synthesis of silver particles 2>

Silver particles 2 dispersed in a solvent were produced by the following procedure. 50-mL glass centrifuge tubes containing a magnetic stirring bar were charged with ricinoleic acid (0.13 g), N,N-diethyl-1,3-diaminopropane (4.1 g), 1-butanol (3.8 g), and ethylene glycol (3.8 g), followed by stirring for about 1 minute, and then charged with silver oxalate (5 g), followed by stirring for about 10 minutes, affording a silver particles 2-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of 2-ethylhexanoic acid was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. Next, the process including addition of 15 g of 2-ethyl-1,3-hexanediol, stirring, centrifugation, and removal of the supernatant was repeated twice, and then silver particles 2 were collected.

<Synthesis Example 3: Synthesis of silver particles 3>

Silver particles 3 dispersed in a solvent were produced by the following procedure. 50-mL glass centrifuge tubes containing a magnetic stirring bar were charged with 2-(2-aminoethylamino)ethanol (1.74 g) and 1-butanol (7.5 g), followed by stirring for about 1 minute, and then charged with silver oxalate (5 g), followed by stirring for about 10 minutes, affording a silver particles 3-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of 2-ethylhexanoic acid was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by

Hitachi Koki Co., Ltd.) at 2500 rpm (centrifugal acceleration of about 1110 xG) for 1 minute, and the supernatant was removed by tilting the centrifuge tubes. Next, the process including addition of 15 g of 2-ethyl-1,3-hexanediol, stirring, centrifugation, and removal of the supernatant was repeated twice, and then silver particles 3 were collected.

<Synthesis Example 4: Synthesis of silver particles 4>

Silver particles 4 dispersed in a solvent were produced by the following procedure. 50-mL glass centrifuge tubes containing a magnetic stirring bar were charged with ricinoleic acid (0.05 g), N,N-diethyl-1,3-diaminopropane (4.1 g), and 1-butanol (7.5 g), followed by stirring for about 1 minute, and then charged with silver oxalate (5 g), followed by stirring for about 10 minutes, affording a silver particles 4-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of 2-hydroxyisobutyric acid was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. Next, the process including addition of 15 g of 2-ethyl-1,3-hexanediol, stirring, centrifugation, and removal of the supernatant was repeated twice, and then silver particles 4 were collected.

<Synthesis Example 5: Synthesis of silver particles 5>

Silver particles 5 dispersed in a solvent were produced by the following procedure. 50-mL glass centrifuge tubes containing a magnetic stirring bar were charged with ricinoleic acid (0.13 g), N,N-diethyl-1,3-diaminopropane (4.1 g), 1-butanol (3.8 g), and ethylene glycol (3.8 g), followed by stirring for about 1 minute, and then charged with silver oxalate (5 g), followed by stirring for about 10 minutes, affording a silver particles 5-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of 2-hydroxyisobutyric acid was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. Next, the process including addition of 15 g of 2-ethyl-1,3-hexanediol, stirring, centrifugation, and removal of the supernatant was repeated twice, and then silver particles 5 were collected.

<Synthesis Example 6: Synthesis of silver particles 6>

Silver particles 6 dispersed in a solvent were produced by the following procedure. 50-mL glass centrifuge tubes containing a magnetic stirring bar were charged with 2-(2-aminoethylamino)ethanol (1.74 g) and 1-butanol (7.5 g), followed by stirring for about 1 minute, and then charged with silver oxalate (5 g), followed by stirring for about 10 minutes, affording a silver particles 6-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. The process including addition of 15 g of isopropyl alcohol, stirring, centrifugation, and removal of the supernatant was repeated twice,

and then silver particles were collected. Next, using the dispersion (isopropyl alcohol solution) of the silver particles obtained above, 15 g of 2-hydroxyisobutyric acid was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. Next, the process including addition of 15 g of 2-ethyl-1,3-hexanediol, stirring, centrifugation, and removal of the supernatant was repeated twice, and then silver particles 6 were collected.

<Synthesis Example 7: Synthesis of silver particles 7>

Silver particles 7 dispersed in a solvent were produced by the following procedure. 50-mL glass centrifuge tubes containing a magnetic stirring bar were charged with ricinoleic acid (0.05 g), N,N-diethyl-1,3-diaminopropane (4.1 g), and 1-butanol (7.5 g), followed by stirring for about 1 minute, and then charged with silver oxalate (5 g), followed by stirring for about 10 minutes, affording a silver particles 7-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of n-hexylamine was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. Next, the process including addition of 15 g of diethylene glycol mono-2-ethylhexyl ether, stirring, centrifugation, and removal of the supernatant was repeated twice, and then silver particles 7 were collected.

<Synthesis Example 8: Synthesis of silver particles 8>

Silver particles 8 dispersed in a solvent were produced by the following procedure. 50-mL glass centrifuge tubes containing a magnetic stirring bar were charged with ricinoleic acid (0.13 g), N,N-diethyl-1,3-diaminopropane (4.1 g), 1-butanol (3.8 g), and ethylene glycol (3.8 g), followed by stirring for about 1 minute, and then charged with silver oxalate (5 g), followed by stirring for about 10 minutes, affording a silver particles 8-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of n-hexylamine was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 3000 rpm (centrifugal acceleration of about 1600 xG) for 1 minute, and the supernatant was removed by tilting the centrifuge tubes. Next, the process including addition of 15 g of diethylene glycol mono-2-ethylhexyl ether, stirring, centrifugation, and removal of the supernatant was repeated twice, and then silver particles 8 were collected.

<Synthesis Example 9: Synthesis of silver particles 9>

Silver particles 9 dispersed in a solvent were produced by the following procedure. 50-mL glass centrifuge tubes containing a magnetic stirring bar were charged with 2-(2-aminoethylamino)ethanol (1.74 g) and 1-butanol (7.5 g), followed by stirring for about 1 minute, and then charged with silver oxalate (5 g), followed by stirring for about 10 minutes, affording a silver particles 9-preparation composition. Thereafter, these glass centrifuge tubes were set upright on a hot stirrer equipped with an aluminum block (HHE-19G-U manufactured by Koike Precision Instruments), stirred at 40°C for 30 minutes, and additionally stirred at 90°C for 30 minutes. After allowing to cool, the magnetic stirring bar was removed, 15 g

of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. The process including addition of 15 g of isopropyl alcohol, stirring, centrifugation, and removal of the supernatant was repeated twice, and then silver particles were collected. Next, using the dispersion (isopropyl alcohol solution) of the silver particles obtained above, 15 g of n-hexylamine was added, and the mixture was stirred at room temperature for 4 hours. After stirring, the magnetic stirring bar was removed, 15 g of isopropyl alcohol was added to each composition and stirred with a vortex mixer, the composition was then subjected to centrifugal sedimentation in a centrifuge (CF7D2 manufactured by Hitachi Koki Co., Ltd.) at 2500 rpm (centrifugal acceleration of about 1110 xG) for 1 minute, and the supernatant was removed by tilting the centrifuge tubes. Next, the process including addition of 15 g of diethylene glycol mono-2-ethylhexyl ether, stirring, centrifugation, and removal of the supernatant was repeated twice, and then silver particles 9 were collected.

For each of the obtained silver particles 1 to 9, observation with a scanning electron microscope (acquisition of an SEM image), measurement of average particle diameter (volume-based average particle diameter), measurement of particle size distribution, and TG-DTA measurement were conducted under the following conditions.

<Observation with electron microscope>

For each of the silver particles obtained in Examples and Comparative Examples, an SEM image was acquired using a scanning electron microscope (SEM (JSM-IT500HR from JEOL Ltd.)).

<Measurement of average particle diameter (volume-based average particle diameter)>

For each of the SEM images (lateral width: 1 to 20 μm) acquired in <Observation with electron microscope> above, the volume-based average particle diameter (primary particle diameter) of 200 randomly selected particles was measured using image analysis software (Macview (available from Mountech Co., Ltd.)). With respect to the vertical direction of the SEM image, a range with a lateral width of 1 to 20 μm was observed. With respect to the vertical direction of the SEM image, the width is set such that 200 or more (typically about 200 to about 300) silver particles are included in the range with a lateral width of 1 to 20 μm. The volume-based average particle diameter refers to the value measured on the basis of the assumption that the particles observed in the SEM image have a spherical shape with that diameter. The results are shown in Table 1.

<Photocentrifuge Method>

For each of the obtained silver particles 1 to 9, the value of SPAN shown below was obtained by the photocentrifuge method.

$$\text{SPAN: } (X90 - X10)/X50 \cdots \text{ Expression (1)}$$

wherein when the particle diameter is expressed by a cumulative distribution,
X10 is a particle diameter at 10% of a cumulative particle size distribution;
X90 is a particle diameter at 90% of the cumulative particle size distribution;
X50 (median particle diameter) is a particle diameter at 50% of the cumulative particle size distribution.

(Measurement conditions for SPAN)

A measurement sample in which the concentration of the silver particles in the solvent was 50% by mass was prepared; A solvent having an octanol/water partition coefficient (Log Pow) of -2 or more and 4 or less was used as the solvent of a measurement sample; Each of the silver particles (1 to 9) was taken into a 50 ml vial, and then diluted using 2-ethyl-1,3-hexanediol for the silver particles 1 to 6, and diethylene glycol mono-2-ethylhexyl ether for the silver particles 7 to 9 such that the content of silver was 50% by mass, the content of the solvent was 50% by mass, and the total thereof was 100%. A vortex mixer was used for kneading, and each of the resulting mixtures was dispersed at 2000 rpm for 2 minutes. At this time, if the mixture perceptibly looks not to be dispersed (a solid remains), the mixture may be dispersed by coarse kneading using a spatula or the like, or with a rotation/revolutiontype mixer, or the like. When a rotation/revolution-type mixer is used, stirring is conducted such that particles do not settle with rotation and revolution balanced. When a silver particle dispersion including silver particles dispersed is served as a measurement target and a measurement sample is prepared therefrom, the measurement sample is prepared using a solvent the same as the solvent having dispersed the

silver particles as a diluent. When a plurality of solvents is used in the dispersion, a plurality of solvents may be used, and the dispersion is diluted with the solvents in such a proportion that the solvents are equal in amount to the dispersion. The measurement of SPAN ((X90 - X10)/X50) was conducted with a dispersibility evaluation/particle size distribution analyzer LS-610 manufactured by LUM Japan Co., Ltd. Specifically, a glass cell (a glass cell with an optical path length of 2 mm) was charged with 0.2 ml of the measurement sample; under a condition of 25°C, the glass cell was rotated at a low speed at a centrifugal acceleration of 130 G, and data for 500 points were obtained at an interval of 5 seconds, and then the glass cell was rotated at a high speed at a centrifugal acceleration of 1160 G, and data for 500 points were obtained at an interval of 5 seconds; three points between a gas-liquid interface (the liquid surface of the measurement sample) and a solid-liquid interface (the interface between sedimented silver particles and the solvent) of the measurement sample were arbitrarily selected, and each of the three points was analyzed at a node width of 1 mm; each of the sedimentation velocities was calculated from a moving distance of the particles and a time required for the movement, the sedimentation velocities were converted into particle diameters using the viscosity and the refractive index of the solvent used, whereby the particle diameters X90, X10, and X50 were determined; and the SPAN was calculated based on Expression (1). The LightFactor during measurement was set to 6. It is noted that if a glass cell is not used during measurement, the silver particles may stick and light may be blocked, which hinders accurate measurement of the optical density (absorbance). In addition, if the LightFactor is not set to 6, the intensity of light is insufficient due to the nature of the high-concentration metal particle dispersion to be measured. Therefore, to measure the state of secondary particles of the high-concentration particle dispersion, it is necessary to set the LightFactor to 6. When the form of the secondary particles is measured by the same principle, consideration needs to be given to the light source of the measurement apparatus. In addition, if the nodes (analysis widths) overlap each other, an appropriate number of points cannot be obtained as the number of measured profiles (the number of measurement points). Therefore, the analysis needs to be conducted such that the nodes do not overlap each other. The measurement results are shown in Table 1.

<Production of conductive adhesive>

Using each of the silver particles obtained in Examples and Comparative Examples, a conductive adhesive was produced by the following procedure.

Conductive adhesives were prepared by mixing the silver particles 1 to 9 obtained in Synthesis Examples and a solvent (2-ethyl-1,3-hexanediol for silver particles 1 to 6, diethylene glycol mono-2-ethylhexyl ether for silver particles 7 to 9). Specifically, for each of the silver particles 1 to 9, diethylene glycol mono-2-ethylhexyl ether was added such that the content of silver in the conductive adhesive was 90% by mass, whereby silver particle dispersions having a concentration of 90% by mass were prepared. For mixing, MAZERUSTAR manufactured by Kurabo Industries Ltd. was used, and mixing was performed with a two-time stirring priority mode. Thus, conductive adhesives to be used for producing sintered bodies were obtained.

<Production of sintered body (in air)>

Each of the dispersions (conductive adhesives) of silver particles obtained in Examples and Comparative Examples was sintered in an air atmosphere, and thus sintered bodies were produced. First, an Ag-plated Cu substrate (plating thickness: 3μm) was prepared. A conductive adhesive (a silver particle dispersion composed of 90% by mass of silver particles and 10% by mass of 2-ethyl-1,3-hexanediol for silver particles 1 to 6 or diethylene glycol mono-2-ethylhexyl ether for silver particles 7 to 9) was uniformly applied onto the substrate (the surface on which silver plating was formed) to a thickness of 50 μm. Further, a silicon wafer (size: 2 mm × 2 mm) whose back surface (surface coming into contact with the conductive adhesive) was gold-plated (thickness: 1 μm) was put on the applied layer, affording a laminate. Next, the obtained laminate was heated using a drier (circulation type) under sintering conditions of a prescribed sintering temperature (the temperature was raised to 200°C or 225°C at a heating rate of 3°C/min and kept at (200°C or 225°C) for 60 minutes), and each conductive adhesive between the substrate and the silicon wafer was sintered, yielding nine laminates in which the substrate and the silicon wafer were joined with the sintered body interposed therebetween.

<Production of sintered body (in nitrogen)>

Each of the dispersions (conductive adhesives) of silver particles obtained in Examples and Comparative Examples was sintered in a nitrogen gas atmosphere, and thus sintered bodies were produced. First, an Ag-plated Cu substrate and an Au-plated Cu substrate (plating thickness: 50 nm), and a bare Cu (C1020) substrates were prepared. Next, a conductive adhesive (a silver particle dispersion composed of 90% by mass of silver particles and 10% by mass of 2-ethyl-1,3-hexanediol for silver particles 1 to 6 or diethylene glycol mono-2-ethylhexyl ether for silver particles 7 to 9) was uniformly applied onto the surface of each of the substrates to a thickness of 50 μm. Further, a silicon wafer (size: 2 mm × 2 mm) whose back surface (surface coming into contact with the conductive adhesive) was gold-plated was put on the

applied layer, affording a laminate. Next, the obtained laminate was heated using a nitrogen furnace under sintering conditions of a prescribed sintering temperature (the temperature was raised to 200°C or 225°C at a heating rate of 3°C/min and kept at (200°C or 225°C) for 60 minutes), and each conductive adhesive between the substrate and the silicon wafer was sintered, yielding nine laminates in which the substrate and the silicon wafer were joined with the sintered body interposed therebetween.

<Mechanical strength (shear strength) of sintered body>

For each of the laminates obtained in the production of the sintered body described above, the maximum load at break was measured by conducting a die shear test for each laminate by applying a load on the sintered body under a condition of 0.120 mm/s at room temperature using a bond tester (SS30-WD available from Seishin Trading Co., Ltd.). The maximum load thus obtained was divided by the joining area, yielding a shear strength value. The measurement result is an average value of nine gold-plated silicon wafers whose shear strength has been measured. The measurement results of the shear strength are shown in Tables 1 to 3.

[Table 1]

| Table 1 | | Example 1 | Comparative Example 1 | Comparative Example 2 |
|---|---|---|---|---|
| Silver particles | Average particle diameter (nm) | 68.5 | 81.3 | 76.8 |
| | Silver particles | Silver particles 1 | Silver particles 4 | Silver particles 7 |
| | Protective layer | 2EHA*1 | HBA*2 | HA*3 |
| | Solvent | EHD*4 | EHD*4 | EHDG*5 |
| Evaluation by photocentrifuge method | x10[nm] | 401.1 | 550.7 | 64.7 |
| | x50[nm] | 1351 | 7633 | 200.9 |
| | x90[nm] | 5274 | 17861 | 250.2 |
| | (x90-x10)/x50 | 3.607 | 2.268 | 0.9236 |
| Shear strength of sintered body (MPa) (Atmosphere: air) | Substrate surface: Ag Sintering conditions: 200°C × 1 h (3°C/min) | 28.8 | 97.0 | 102.4 |
| | Substrate surface: Ag Sintering conditions: 225°C × 1 h (3°C/min) | 49.6 | 68.1 | 6.8 |
| Shear strength of sintered body (MPa) (Atmosphere: N2) | Substrate surface: Ag Sintering conditions: 250°C × 1 h (3°C/min) | 98.6 | 59.2 | 45.8 |
| | Substrate surface: Au Sintering conditions: 250°C × 1 h (3°C/min) | 79.0 | 62.1 | 42.3 |
| | Substrate surface: Cu Sintering conditions: 250°C × 1 h (3°C/min) | 91.7 | 13.0 | 26.1 |
| *1; 2EHA (2-Ethylhexanoic acid)<br>*2; HBA (2-Hydroxyisobutyric acid)<br>*3; HA (Hexylamine)<br>*4; EHD (2-Ethyl-1,3-hexanediol)<br>*5; EHDG (Diethylene glycol mono-2-ethylhexyl ether) | | | | |

As is apparent from the results shown in Table 1, in the case of the silver particles of Example 1 in which 2-ethylhexanoic acid was used for a protective layer, the mechanical strength of a sintered body obtained under a nitrogen gas atmosphere (particularly, a sintered body formed on the surface of a copper substrate) was very high as a conductive

adhesive using silver particles having an average particle diameter of about 100 nm, as compared with the cases of conventional silver particles (Comparative Examples 1 and 2) in which 2-hydroxyisobutyric acid or n-hexylamine was used for a protective layer. The conductive adhesive using silver particles having an average particle diameter of about 100 nm can be particularly suitably used for applications in which sintering in a nitrogen gas atmosphere is required, such as a bonding portion of a power device in a thin film and the solar cell application.

[Table 2]

| Table 2 | | Example 2 | Comparative Example 3 | Comparative Example 4 |
|---|---|---|---|---|
| Silver particles | Average particle diameter (nm) | 247 | 307.1 | 251.8 |
| | Silver particles | Silver particles 2 | Silver particles 5 | Silver particles 8 |
| | Protective layer | 2EHA*1 | HBA*2 | HA*3 |
| | Solvent | EHD*4 | EHD*4 | EHDG*5 |
| Evaluation by photocentrifuge method | x10[nm] | 1264 | 1388 | 2249 |
| | x50[nm] | 4382 | 3849 | 3833 |
| | x90[nm] | 12422 | 8531 | 9776 |
| | (x90-x10)/x50 | 2.546 | 1.85 | 1.964 |
| Shear strength of sintered body (MPa) (Atmosphere: air) | Substrate surface: Ag Sintering conditions: 200°C × 1 h (3°C/min) | 61.2 | 64.7 | 121.5 |
| | Substrate surface: Ag Sintering conditions: 225°C × 1 h (3°C/min) | 50.8 | 50.3 | 28.5 |
| Shear strength of sintered body (MPa) (Atmosphere: N2) | Substrate surface: Ag Sintering conditions: 250°C × 1 h (3°C/min) | 92.7 | 86.8 | 45.1 |
| | Substrate surface: Au Sintering conditions: 250°C × 1 h (3°C/min) | 72.1 | 58.8 | 40.7 |
| | Substrate surface: Cu Sintering conditions: 250°C × 1 h (3°C/min) | 20.3 | 3.4 | 9.6 |
| *1; 2EHA (2-Ethylhexanoic acid)<br>*2; HBA (2-Hydroxyisobutyric acid)<br>*3; HA (Hexylamine)<br>*4; EHD (2-Ethyl-1,3-hexanediol)<br>*5; EHDG (Diethylene glycol mono-2-ethylhexyl ether) | | | | |

As is apparent from the results shown in Table 2, in the case of the silver particles of Example 2 in which 2-ethylhexanoic acid was used for a protective layer, the mechanical strength of a sintered body obtained under a nitrogen gas atmosphere (particularly, a sintered body formed on the surface of a copper substrate) was very high as a conductive adhesive using silver particles having an average particle diameter of about 200 nm, as compared with the cases of conventional silver particles (Comparative Examples 3 and 4) in which 2-hydroxyisobutyric acid or n-hexylamine was used for a protective layer. The conductive adhesive using silver particles having an average particle diameter of about 200 nm can be particularly suitably used for applications in which sintering in a nitrogen gas atmosphere is required, such as a bonding portion of a power device or a power amplifier.

[Table 3]

| Table 3 | | Example 3 | Comparative Example 5 | Comparative Example 6 |
|---|---|---|---|---|
| Silver particles | Average particle diameter (nm) | 444.5 | 498.1 | 553.5 |
| | Silver particles | Silver particles 3 | Silver particles 6 | Silver particles 9 |
| | Protective layer | 2EHA*1 | HBA*2 | HA*3 |
| | Solvent | EHD*4 | EHD*4 | EHDG*5 |
| Evaluation by photocentrifuge method | x10[nm] | 956 | 1131 | 868.2 |
| | x50[nm] | 10593 | 2202 | 1117 |
| | x90[nm] | 17556 | 5537 | 3229 |
| | (x90-x10)/x50 | 1.567 | 2.001 | 2.112 |
| Shear strength of sintered body (MPa) (Atmosphere: air) | Substrate Surface: Ag Sintering conditions: 200°C × 1 h (3°C/min) | 47.4 | 114.4 | 70.3 |
| | Substrate Surface: Ag Sintering conditions: 225°C × 1 h (3°C/min) | 22.0 | 20.4 | 9.9 |
| Shear strength of sintered body (MPa) (Atmosphere: N2) | Substrate Surface: Ag Sintering conditions: 250°C × 1 h (3°C/min) | 63.4 | 64.8 | 39.8 |
| | Substrate Surface: Au Sintering conditions: 250°C × 1 h (3°C/min) | 60.7 | 57.8 | 40.1 |
| | Substrate Surface: Cu Sintering conditions: 250°C × 1 h (3°C/min) | 13.6 | 0.1 | 5.6 |
| *1; 2EHA (2-Ethylhexanoic acid)<br>*2; HBA (2-Hydroxyisobutyric acid)<br>*3; HA (Hexylamine)<br>*4; EHD (2-Ethyl-1,3-hexanediol)<br>*5; EHDG (Diethylene glycol mono-2-ethylhexyl ether) | | | | |

As is apparent from the results shown in Table 3, in the case of the silver particles of Example 3 in which 2-ethylhexanoic acid was used for a protective layer, the mechanical strength of a sintered body obtained under a nitrogen gas atmosphere (particularly, a sintered body formed on the surface of a copper substrate) was very high as a conductive adhesive using silver particles having an average particle diameter of about 500 nm, as compared with the cases of conventional silver particles (Comparative Examples 5 and 6) in which 2-hydroxyisobutyric acid or n-hexylamine was used for a protective layer. The conductive adhesive using silver particles having an average particle diameter of about 500 nm can be particularly suitably used for applications in which sintering in a nitrogen gas atmosphere is required, such as a bonding portion of a power device in a thick film.

## Claims

**1.** Silver particles in each of which a compound represented by the following general formula (1) is attached to a surface of the silver particle.

[Chemical Formula 1]

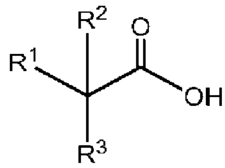

(1)

In general formula (1), $R^1$ is an alkyl group having 2 to 8 carbon atoms, $R^2$ is an alkyl group having 1 to 4 carbon atoms, and $R^3$ is a hydrogen atom or an alkyl group having 1 to 4 carbon atoms.

**2.** The silver particles according to claim 1, wherein the silver particles have an average particle diameter of 60 to 600 nm.

**3.** The silver particles according to claim 1, wherein the silver particles are dispersed in a solvent.

**4.** The silver particles according to claim 3, wherein when a concentration of the silver particles in the solvent is 50% by mass, a value of SPAN as measured by a photocentrifuge method under the following conditions is 0.1 or more and 5.0 or less.

$$\text{SPAN: } (X90 - X10)/X50 \cdots \text{Expression (1)}$$

wherein when the particle diameter is expressed by a cumulative distribution,
X10 is a particle diameter at 10% of a cumulative particle size distribution;
X90 is a particle diameter at 90% of the cumulative particle size distribution;
X50 (median particle diameter) is a particle diameter at 50% of the cumulative particle size distribution.
(Measurement conditions for SPAN)
A measurement sample in which the concentration of the silver particles in the solvent is 50% by mass is prepared; a solvent having an octanol/water partition coefficient (Log Pow) of -2 or more and 4 or less is used as the solvent of the measurement sample; a glass cell (a glass cell with an optical path length of 2 mm) is charged with 0.2 ml of the measurement sample; under a condition of 25°C, the glass cell is rotated at a low speed at a centrifugal acceleration of 130 G, and data for 500 points are obtained at an interval of 5 seconds, and then the glass cell is rotated at a high speed at a centrifugal acceleration of 1160 G, and data for 500 points are obtained at an interval of 5 seconds; three points between a gas-liquid interface (the liquid surface of the measurement sample) and a solid-liquid interface (the interface between sedimented silver particles and the solvent) of the measurement sample are arbitrarily selected, and each of the three points is analyzed at a node width of 1 mm; each of the sedimentation velocities is calculated from a moving distance of the particles and a time required for the movement, the sedimentation velocities are converted into particle diameters using the viscosity and the refractive index of the solvent used, whereby the particle diameters X90, X10, and X50 are determined; and the SPAN is calculated based on Expression (1).

**5.** A conductive adhesive comprising the silver particles according to claim 1 or 2.

**6.** A conductive adhesive comprising the silver particles according to claim 1 or 2 and a resin.

**7.** A sintered body of the conductive adhesive according to claim 5.

**8.** An electronic part in which members are bonded with the sintered body according to claim 7.

## INTERNATIONAL SEARCH REPORT

International application No.
**PCT/JP2024/031078**

### A. CLASSIFICATION OF SUBJECT MATTER

***B22F 1/102***(2022.01)i; ***B22F 1/00***(2022.01)i; ***B22F 1/054***(2022.01)i; ***B22F 9/00***(2006.01)i; ***B22F 9/24***(2006.01)i; ***H01B 1/00***(2006.01)i; ***H01B 1/22***(2006.01)i; ***H01B 5/00***(2006.01)i; ***H01L 21/52***(2006.01)i
FI: B22F1/102; B22F1/00 K; B22F1/054; B22F9/00 A; B22F9/24 E; B22F9/24 F; H01B1/00 E; H01B1/22 D; H01B5/00 E; H01L21/52 E

According to International Patent Classification (IPC) or to both national classification and IPC

### B. FIELDS SEARCHED

Minimum documentation searched (classification system followed by classification symbols)

B22F1/102; B22F1/00; B22F1/054; B22F9/00; B22F9/24; H01B1/00; H01B1/22; H01B5/00; H01L21/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2012-052198 A (NIPPON HANDA K.K.) 15 March 2012 (2012-03-15) claims, paragraphs [0008], [0022], [0024], [0046], [0073], [0079] | 1-8 |
| A | JP 2019-087396 A (MITSUBISHI MATERIALS CORPORATION) 06 June 2019 (2019-06-06) | 1-8 |
| A | WO 2021/025003 A1 (DAICEL CORP.) 11 February 2021 (2021-02-11) paragraph [0019] | 1-8 |
| A | JP 2022-117824 A (OSAKA SODA CO., LTD.) 12 August 2022 (2022-08-12) | 1-8 |

☐ Further documents are listed in the continuation of Box C.    ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 October 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/031078**

| Patent document cited in search report | Publication date (day/month/year) | Patent family member(s) | Publication date (day/month/year) |
|---|---|---|---|
| JP 2012-052198 A | 15 March 2012 | (Family: none) | |
| JP 2019-087396 A | 06 June 2019 | (Family: none) | |
| WO 2021/025003 A1 | 11 February 2021 | US 2022/0275247 A1<br>paragraph [0020]<br>EP 4012726 A1<br>CN 114270453 A<br>KR 10-2022-0042428 A<br>TW 202113876 A | |
| JP 2022-117824 A | 12 August 2022 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015159096 A
- JP 5574761 B